# EUROPÄISCHE PATENTSCHRIFT

(11) **EP 2 550 556 B1**
(45) Veröffentlichungstag und Bekanntmachung des Hinweises auf die Patenterteilung: **10.06.2015**
(21) Anmeldenummer: 11704551.8
(22) Anmeldetag: 17.02.2011
(51) Int. Cl.: G02F 1/13

(54) **DISPLAY-ANORDNUNG UND DEREN MONTAGE**
DISPLAY ARRANGEMENT AND THE MOUNTING THEREOF
DISPOSITIF D'AFFICHAGE ET MONTAGE DUDIT DISPOSITIF D'AFFICHAGE

(30) Priorität: 29.09.2010 DE 102010046874; 22.03.2010 DE 102010012372
(43) Veröffentlichungstag der Anmeldung: 30.01.2013
(73) Patentinhaber: Johnson Controls Automotive Electronics GmbH, 75196 Remchingen (DE)
(72) Erfinder: ARHEIT, Thomas, 76356 Weingarten (DE)
(74) Vertreter: Wolff, Felix
(86) Internationale Anmeldenummer: PCT/EP2011/000758
(87) Internationale Veröffentlichungsnummer: WO 2011/116856

(56) Entgegenhaltungen:
- EP-A2- 0 302 189
- EP-A2- 0 695 964
- US-A1- 2006 209 227

## Beschreibung

Die Erfindung betrifft eine Display-Anordnung und deren Montage.

Aus dem Stand der Technik ist es bekannt, ein TFT-*(Thin Film Transistor)-*Display mittels Positionier-Elementen in Form von Schraubdorn-Positionierstift-Kombinationen bezüglich eines Trägerteils zu positionieren und mittels Verschraubung mit dem Trägerteil zu fixieren. Eine anschließend mit einem Trägerteil montierte Frontblende muss dann in einem gewissen Abstand zum TFT-Display positioniert werden, um eine Dickentoleranz des TFT-Displays (ca. 0,3mm) auszugleichen und um zu verhindern, dass Druck auf die Vorderseite des TFT-Displays ausgeübt wird. Dieser zwingend erforderliche Abstand führt letztlich zu Schwierigkeiten hinsichtlich der Parallaxe, weil zwar keine Pixel der Anzeige verdeckt werden sollen zugleich jedoch der Rahmen des TFT-Displays unter allen Betrachtungswinkeln nicht sichtbar sein sollte.

Die Druckschrift US 2006/0209227 A1 zeigt eine LCD-Vorrichtung, bei der die Anzeigeeinheit mittels einer außenseitlich angebrachten, beweglichen Lasche an einem Zwischenrahmen geklemmt wird, wenn die Frontblende auf die Vorrichtung abgesenkt und montiert wird. Der Erfindung liegt die Aufgabe zugrunde, eine Display-Anordnung und deren Montage vorzuschlagen, die ohne frontseitige Druckbelastung der Anzeigeeinheit auskommt und die zuvor beschriebenen Nachteile des Standes der Technik überwindet.

Gelöst wird die Aufgabe mit einer Display-Anordnung gemäß Anspruch 1.

Die vorliegende Erfindung betrifft eine Displayanzeige. Bei dieser Displayanzeige kann es sich um eine beliebige, dem Fachmann geläufige Displayanzeige, beispielsweise eine TFT-, LCD- und/oder OLED-Anzeige handeln.

Desweiteren weist die erfindungsgemäße Display-Anordnung ein Frontteil auf, wobei zwischen dem Frontteil und der Anzeige ein Zwischenteil vorgesehen ist. Dieses Zwischenteil kann zum einen der Vorfixierung der Anzeige an dem Frontteil und/oder zur Verbindung des Frontteils mit der Anzeige dienen.

Erfindungsgemäß ist nun vorgesehen, dass das Zwischenteil mit der Anzeige reibschlüssig verbunden ist. Dabei wird der Reibschluss dadurch erzeugt, dass zumindest Abschnitte des Zwischenteils gegen die Anzeige gedrückt werden.

Bei dem Zwischenteil handelt es sich deshalb um ein rahmenartiges Zwischenteil, das aus einem elastischen Werkstoff, beispielsweise einem Gummiwerkstoff und/oder einem schaumartigen Werkstoff gefertigt ist. Dieses Zwischenteil wird bei der Montage der Display-Anordnung elastisch deformiert und dabei zumindest teilweise in Richtung des Displays gedrückt, wodurch der Reibschluss entsteht. Ein elastisches Zwischenteil hat außerdem den Vorteil, dass vergleichsweise grobe Fertigungstoleranzen zugelassen werden können. In einer bevorzugten Ausführungsform dient das Zwischenteil auch als Dichtung, um das Eindringen von Schmutz und/oder Feuchtigkeit in die erfindungsgemäße Display-Anordnung zu verhindern.

Dabei weist das Zwischenteil mindestens eine Ausnehmung auf, in die ein Spreizmittel, das an dem Trägerteil vorgesehen ist, spreizend eingreift. Das Spreizmittel, insbesondere dessen Querschnitt, ist, zumindest abschnittsweise, größer dimensioniert als der Querschnitt der Ausnehmung. Dadurch spreizt/weitet das Spreizmittel die Ausnehmung. Vorzugsweise verjüngt sich das Spreizmittel von dem Trägerteil zur Spitze des Spreizmittels hin. Dabei ist das Spreizmittel keilartig vorgesehen. Durch dieses Spreizmittel erfolgt die elastische Deformation des Zwischenteils. Vorzugsweise wird das Zwischenteil zwischen dem Trägerteil und dem Frontteil eingespannt. Vorzugsweise weist das Zwischenteil eine Vielzahl von Ausnehmungen auf, zu denen komplementär angeordnete Spreizmittel an dem Trägerteil vorgesehen sind. Vorzugsweise sind die Ausnehmungen bezüglich einer Mittelachse der Anzeige symmetrisch vorgesehen.

In einer bevorzugten Ausführungsform weist die Display-Anordnung eine Frontscheibe auf.

Vorzugsweise ist die Frontscheibe mit der Anzeige verbunden, insbesondere stoffschlüssig verbunden. Für diesen Stoffschluss eignet sich insbesondere ein optischer Klebstoff.

Vorzugsweise ist das Frontteil der Display-Anordnung mit einer Blende versehen. Vorzugsweise ist an dieser Blende eine Frontscheibe angeordnet.

Ein weiterer Gegenstand der vorliegenden Erfindung ist ein Verfahren zur Montage der erfindungsgemäßen Display-Anordnung, bei dem die Anzeige in das Frontteil eingelegt und reibschlüssig mit dem Zwischenteil verbunden wird.

Die zu der erfindungsgemäßen Display-Anordnung gemachten Ausführungen gelten für das erfindungsgemäße Verfahren gleichermaßen und umgekehrt.

Dabei wird das Zwischenteil zumindest teilweise von einem Trägerteil verformt. Weiterhin bevorzugt wird das Trägerteil mit dem Frontteil verbunden. Insbesondere erfolgt dieser Verbund durch einen Schraub- oder Schnappverschluss, ganz besonders bevorzugt Werkzeuglos. Die Spreizelemente können dabei als Begrenzungsmittel dienen, um das Zwischenteil nicht zu sehr zu verformen.

Ein Aspekt der Erfindung besteht demnach insbesondere darin, dass in einen Zwischenraum, der zwischen zwei ersten Komponenten gebildet wird, ein Zwischenteil angeordnet wird, das zum Beispiel eine Vorpositionierung zwischen den beiden ersten Komponenten zueinander gewährleistet. Wenigstens ein Bereich des Zwischenteils ist aus einem elastisch nachgiebigen Material gebildet, während eine weitere, zweite Komponente mit wenigstens einem vergleichsweise formstabilen Pressorgan versehen ist. Beim Zusammenbauen der einzelnen Komponenten zu der Einheit als Display-Anordnung wird der elastisch nachgiebige Bereich durch das Pressorgan verformt und dadurch gegen eine Fläche einer der ersten Komponenten gedrückt.

Im Folgenden wird die Erfindung anhand der Figuren 1 - 3 erläutert. Diese Erläuterungen sind lediglich beispielhaft und schränken den allgemeinen Erfindungsgedanken nicht ein. Die Erläuterungen gelten für beide Gegenstände der vorliegenden Erfindung gleichermaßen.

Es zeigen:
- **Fig. 1**: eine erfindungsgemäße Display-Anordnung; in Explosionsdarstellung;
- **Fig. 2**: ein Detail der Display-Anordnung von Fig. 1 zu einem früheren Zeitpunkt des Zusammenbaus der Display-Anordnung, in einer Schnittdarstellung; und
- **Fig. 3**: die Darstellung von Fig. 2 zu einem späteren Zeitpunkt des Zusammenbaus der Display-Anordnung.

In den folgenden Figuren sind gleiche Bauteile bzw. Elemente mit gleichen Bezugszeichen versehen.

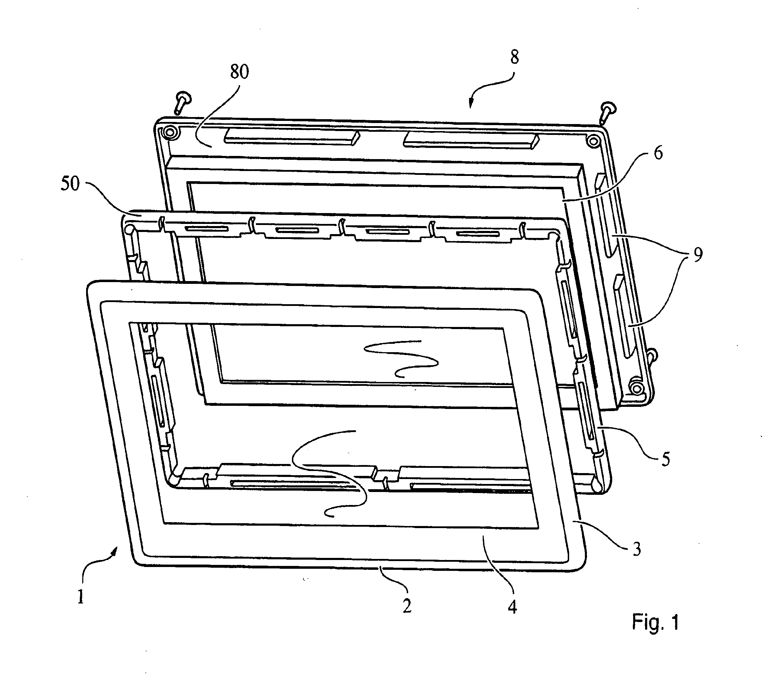

Die in Fig. 1 in Explosionsdarstellung gezeigte erfindungsgemäße Display-Anordnung 1 ist beispielsweise in einem Fahrzeugcockpit angeordnet. Die Display-Anordnung 1 ist nach vorne durch ein Frontteil 2 begrenzt, das eine Frontblende 3 mit integrierter Frontscheibe 4 umfasst. Ein Zwischenteil 5, das aus einem elastisch nachgiebigen Material (z.B. Gummi, Silikon, thermoplastisches Elastomer und/oder Schaumstoff) hergestellt ist, weist eine rahmenartige geometrische Gestaltung auf. Die Display-Anordnung 1 umfasst ferner eine Anzeige, hier eine TFT-Anzeige 6.

Auf einer im montierten Zustand nach vorne weisenden Vorderfläche 50 des Zwischenteils 5 münden Öffnungen 7 (von denen nur einigen ein Bezugszeichen zugeordnet ist) in den Raum. Die Öffnungen 7 sind in regelmäßigen Abständen zueinander um den gesamten Umfang der Vorderfläche 50 herum verteilt angeordnet, wobei auch eine andere Anordnung möglich ist.

Hinter der Anzeige 6 ist ein Trägerteil 8 angeordnet, das einen die Display-Anordnung 1 nach hinten begrenzenden plattenartigen ebenen Grundkörper 80 aufweist. Der Grundkörper 80 ist randseitig mit auf die Öffnungen 7 ausgerichteten Presskeilen 9 (von denen nur einigen ein Bezugszeichen zugeordnet ist) versehen. Die Presskeile 9 sind um den gesamten Umfangsrand des Grundkörper 80 herum verteilt angeordnet.

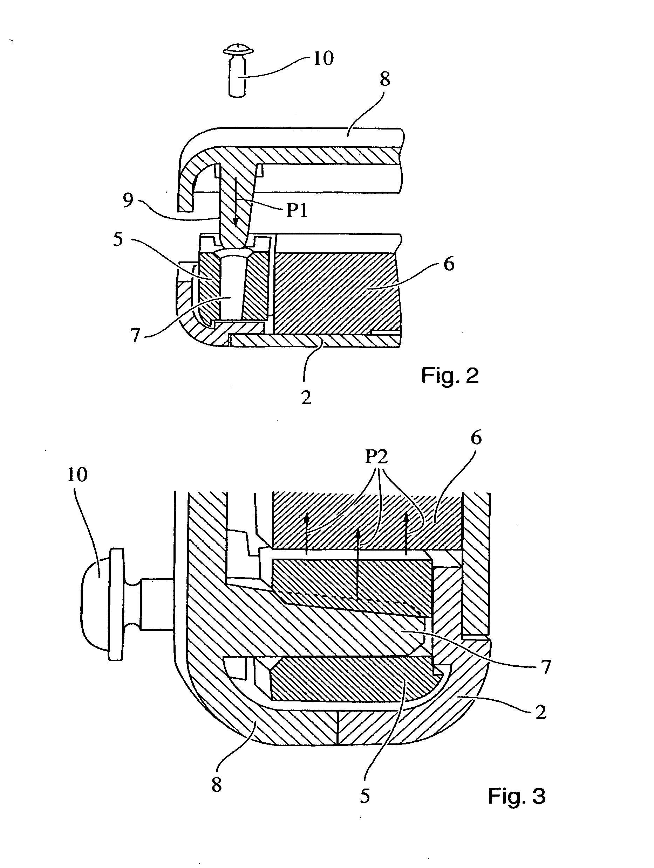

Beim Zusammenbauen der einzelnen Komponenten zur fertigen Display-Anordnung 1 wird zunächst die Anzeige 6 dicht, d.h. zumindest nahezu spaltfrei, am Frontteil 2 anliegend von der Rückseite her in das Frontteil 2 eingesetzt bzw. eingelegt. In den zwischen der Anzeige 6 und der Frontblende 2 gebildeten Zwischenraum, insbesondere der Zwischenraum zwischen dem Außenumfang der Anzeige und dem Innenumfang des Frontteils, wird das Zwischenteil 5 als Vorpositionierung eingesetzt bzw. eingelegt. Im weiteren Verlauf des Zusammenbauens der Display-Anordnung erfolgt dann eine Annäherung des Trägerteils 8 auf das Frontteil 2 bzw. auf das Zwischenteil 5 zu. Diese Annäherung ist in Fig. 2, die ein Detail der Display-Anordnung 1 von Fig. 1 zu dem betreffenden Zeitpunkt des Zusammenbauens zeigt, durch einen ersten Pfeil P1 angedeutet.

Die Presskeile 9 sind auf die Öffnungen 7 so ausgerichtet, dass während einer Phase der Annäherung des Trägerteils 8 auf das Frontteil 2 die Presskeile 9 jeweils in Eingriffe mit mindestens einer Öffnung 7 im Zwischenteil 5 treten.

Aufgrund der sich verbreiternden Keilform der Presskeile 9 wird bei fortschreitender Annäherung des Trägerteils 8 an das Frontteil 2 das Zwischenteil 5 in den betreffenden Bereichen um die Öffnungen 7 zunehmend elastisch verformt und das so verdrängte und der innere Umfang des Zwischenteils 5, zumindest abschnittsweise, gegen eine Fläche der Anzeige 6, insbesondere gegen deren äußeren Umfang, gepresst.

Fig. 3 zeigt die Darstellung von Fig. 2 zu einem gegenüber Fig. 2 späteren Zeitpunkt des Zusammenbaus der Display-Anordnung 1. Die Presskeile 9 sind jetzt tief in die Öffnungen 7 eingedrungen.

Die Richtung der angesprochenen Verformung des Materials, die zugleich die Richtung der Anpresskraft des verdrängten Materials in die Anzeige 6 darstellt, ist durch zweite Pfeile P2 angedeutet.

Sind die Presskeile 9 in ihrer definierten Endstellung angekommen, bewirken sie letztlich ein Verklemmen der Anzeige 6 in der Frontblende 2 und damit Fixierung der Anzeige 6 über Reibung. Anschließend wird die Frontblende 3 mit dem Trägerteil 8 mittels Schrauben 10 befestigt oder verklipst.

Die einzelnen Öffnung-Presskeil-Kombinationen wirken aufeinander abgestimmt, insbesondere erfolgen die Verformungen an den verschiedenen Stellen gleichzeitig, wodurch eine symmetrische Positionierung der Anzeige 6 erreicht wird.

Es ist auch möglich, die Frontscheibe an der Anzeige anzubringen (beispielsweise durch Kleben, mittels optischem Klebstoff, etc.) und danach das entstandene Verbundbauteil aus Anzeige und Frontscheibe so anzuordnen, dass die Frontscheibe flächenbündig mit der Vorderseite der Frontblende angeordnet ist. Auch in diesem Fall erfolgt eine Fixierung nach dem zuvor beschriebenen Prinzip mittels einer elastischen Verformung eines Zwischenteils, das sich zwischen der Frontblende und der Anzeige befindet.

Als Fazit wurde ein neuer Weg zur Positionierung und Fixierung einer Anzeige gezeigt, bei dem eine Ausrichtung der Anzeige bezüglich der Frontblende erfolgt.

Bei der erfindungsgemäßen Positionierung und Fixierung einer Anzeige kann auf rueckseitige Schraubdome und Stifte an der TFT verzichtet werden.

Das Zwischenteil 5 kann so ausgelegt werden, dass es zusätzlich die Funktion einer Dichtung gegen Eindringen von Schmutz von außen in einen Innenbereich der Display-Anordnung 1 erfüllt.

Obgleich die Erfindung einem Beispiel einer TFT- Anzeige erläutert worden ist, ist hierin keine Einschränkung zu sehen. Vielmehr kann die Erfindung statt auf eine TFT- Anzeige auch auf eine Anzeige eines anderen Typs angewendet werden, wie etwa auf eine Lumineszenz- oder Plasmaanzeige, LCD (Liquid Crystal Display), OLED (Organic lightemitting diode), etc.

### Bezugszeichenliste

- 1: Display-Anordnung
- 2: Frontteil
- 3: Blende, Frontblende
- 4: Frontscheibe
- 5: Zwischenteil
- 6: Anzeige, TFT-Anzeige
- 7: Öffnungen
- 8: Trägerteil
- 9: Spreizmittel, Presskeile
- 10: Schraube
- 50: Vorderfläche (des Zwischenteils)
- 80: Grundkörper
- PI: erster Pfeil
- P2: zweite Pfeile

## Patentansprüche

1. Display-Anordnung (1) mit einer Anzeige (6), einem Trägerteil (8) und einem Frontteil (2), wobei zwischen dem Frontteil (2) und der Anzeige (6) ein rahmenartig ausgebildetes Zwischenteil (5) vorgesehen ist, **dadurch gekennzeichnet, dass** das Zwischenteil (5) aus einem elastischen Werkstoff gefertigt ist, wobei das Zwischenteil (5) mindestens eine Ausnehmung (7) aufweist, in die ein Spreizmittel (9), das Bestandteil des Trägerteils (8) ist, spreizend eingreift, und wobei das Spreizmittel (9) keilartig vorgesehen ist, so dass das Zwischenteil (5) mit der Anzeige (6) reibschlüssig verbunden ist.

2. Display-Anordnung (1) nach dem voranstehenden Anspruch, **dadurch gekennzeichnet, dass** sie eine Frontscheibe (4) aufweist.

3. Display-Anordnung (1) nach Anspruch 2, **dadurch gekennzeichnet, dass** die Frontscheibe (4) mit der Anzeige (6) verbunden, insbesondere stoffschlüssig verbunden ist.

4. Display-Anordnung (1) nach einem der voranstehenden Ansprüchen, **dadurch gekennzeichnet, dass** das Frontteil eine Blende (3) aufweist.

5. Display-Anordnung (1) nach Anspruch 4, **dadurch gekennzeichnet, dass** die Fronscheibe (4) an der Blende (3) angeordnet ist.

6. Verfahren zur Montage einer Display-Anordnung nach einem der voranstehenden Ansprüche, **dadurch gekennzeichnet, dass** die Anzeige (6) in das Frontteil (2) eingelegt und reibschlüssig mit dem Zwischenteil (5) verbunden wird.

7. Verfahren nach Anspruch 7, **dadurch gekennzeichnet, dass** das Zwischenteil zumindest teilweise von dem Trägerteil verformt wird.

8. Verfahren nach einem der Ansprüche 6 oder 7, **dadurch gekennzeichnet, dass** das Trägerteil mit dem Frontteil verbunden wird.

## Claims

1. Display configuration (1) having a display (6), a carrier part (8) and a front part (2), wherein an intermediate part (5) of frame-like design is provided between the front part (2) and the display (6), **characterized in that** the intermediate part (5) is produced from an elastic material, wherein the intermediate part (5) has at least one recess (7) with which a splaying means (9), which is an integral part of the carrier part (8), engages in a splaying manner and wherein the splaying means (9) is provided in a wedge-like manner, so that the intermediate part (5) is connected to the display (6) in a frictionally engaged manner.

2. Display configuration (1) according to the preceding claim, **characterized in that** it has a front panel (4).

3. Display configuration (1) according to Claim 2, **characterized in that** the front panel (4) is connected to the display (6), in particular in a substance-bonded manner.

4. Display configuration (1) according to one of the preceding claims, **characterized in that** the front panel (4) is arranged on the faceplate (3).

5. Display configuration (1) according to Claim 4, **characterized in that** the front panel (4) is arranged on the faceplate (3).

6. Method of assembling a display configuration according to one of the preceding claims, **characterized in that** the display (6) is inserted in the front part (2) and connected to the intermediate part (5) in a frictionally engaged manner.

7. Method according to claim 7, **characterized in that** the intermediate part is at least partially deformed by the carrier part.

8. Method according to one of Claims 6 or 7, **characterized in that** the carrier part is connected to the front part.

## Revendications

1. Dispositif d'affichage (1) avec un écran d'affichage (6), un support (8) et une partie antérieure (2), une pièce intermédiaire (5) en forme de cadre étant placée entre la partie antérieure (2) et l'écran d'affichage (6), **caractérisé en ce que** la pièce intermédiaire (5) est réalisée avec un matériau élastique, la pièce intermédiaire (5) présentant au moins un évidement (7) avec lequel un dispositif d'évasement (9), faisant partie intégrante du support (8), s'engage en évasant, et le dispositif d'évasement (9) étant de forme cunéiforme, de manière à ce que la pièce intermédiaire (5) soit raccordée à l'écran d'affichage (6) par un engagement à friction.

2. Dispositif d'affichage (1) selon la revendication précédente, **caractérisé en ce qu'**il présente un panneau antérieur (4).

3. Dispositif d'affichage (1) selon la revendication 2, **caractérisé en ce que** le panneau antérieur (4) est relié à l'écran d'affichage (6), en particulier à l'aide d'une substance d'adhérence.

4. Dispositif d'affichage (1) selon l'une quelconque des revendications précédentes, **caractérisé en ce que** la partie antérieure est disposée sur le plateau (3).

5. Dispositif d'affichage (1) selon la revendication 4, **caractérisé en ce que** le panneau antérieur (4) est disposé sur le plateau (3).

6. Méthode d'assemblage d'un dispositif d'affichage selon l'une quelconque des revendications précédentes, **caractérisé en ce que** l'écran d'affichage (6) est inséré dans la partie antérieure (2) et relié par un engagement à friction à la pièce intermédiaire (5).

7. Méthode selon la revendication 7, **caractérisée en ce que** la pièce intermédiaire est au moins partiellement déformée par le support.

8. Méthode selon l'une quelconque des revendications 6 ou 7, **caractérisée en ce que** le support est raccordé à la partie antérieure.
